# EUROPÄISCHE PATENTSCHRIFT

(11) **EP 0 445 505 B1**
(45) Veröffentlichungstag und Bekanntmachung des Hinweises auf die Patenterteilung: **30.11.1994**
(21) Anmeldenummer: 91100380.4
(22) Anmeldetag: 15.01.1991
(51) Int. Cl.: H01L 27/118

(54) **Basiszelle für eine kanallose Gate-Array-Anordnung**
Basic cell for a channelless gate array device
Cellule de base pour un dispositif de circuit prédiffusé du type "mer de portes"

(30) Priorität: 31.01.1990 DE 4002780
(43) Veröffentlichungstag der Anmeldung: 11.09.1991
(73) Patentinhaber: TEMIC TELEFUNKEN microelectronic GmbH, 74072 Heilbronn (DE)
(72) Erfinder: Tröster, Gerhard, Dr., W-7100 Heilbronn (DE); Esser, Winfried, W-4300 Essen 1 (DE); Rothermel, Albrecht, Dr., W-7730 VS-Villingen (DE); Schardein, Werner, Dr., W-4200 Oberhausen 1 (DE)
(74) Vertreter: Maute, Hans-Jürgen, Dipl.-Ing.

(56) Entgegenhaltungen:
- EP-A- 0 102 644
- PROCEEDINGS OF THE IEEE 1989 CUSTOM INTEGRATED CIRCUITS CONFERENCE, San Diego,CA, 15. - 18. Mai 1989, Seiten 8.3.1-8.3.4; A.E. GAMAL et al.: "BINMOS: A basiccell for BiCMOS sea-of-gates"
- PATENT ABSTRACTS OF JAPAN, Band 12, Nr. 412 (E-676)[3259], 31. Oktober 1988;& JP-A-63 150 935
- PATENT ABSTRACTS OF JAPAN, Band 6, Nr. 251 (E-147)[1129], 10. Dezember 1982;& JP-A-57 148 363

## Beschreibung

Die Erfindung betrifft eine Basiszelle für eine kanallose Gate-Array-Anordnung ("Sea of Gate" (SOG)-Array) in einer CMOS- und Bipolar-Technologie kombinierenden Technik, gemäß dem Oberbegriff des Patentanspruches 1 sowie die Verwendung einer solchen Basiszelle zum Aufbau eines SOG-Arrays.

Eine solche Basiszelle in einer die CMOS- und Bipolar-Technologie kombinierenden Technik (BICMOS-Technik) zum Aufbau eines SOG-Arrays ist aus der Druckschrift "IEEE Proceeding of CICC", 1989, Seiten 8.3.1 bis 8.3.4, insbesondere auf Seite 8.3.3, Figur 1 bekannt. Unter einem SOG-Array versteht man die reguläre Anordnung von Basiszellen, die aus nicht verschalteten Bauelementen aufgebaut ist. Die Realisierung einer Schaltung erfolgt durch Konfigurierung von Kontaktloch- und Metallmasken. Im Gegensatz zu klassischen Gate-Arrays weisen SOG-Arrays keine reservierten Kanäle für die Verdrahtung auf, vielmehr kann die Metallisierung auch über die einzelnen Bauelemente geführt werden. Dieser Verdrahtungstyp erfordert daher mindestens zwei Metallverdrahtungsebenen.

SOG-Arrays in BICMOS-Schaltungstechnik zeichnen sich gegenüber CMOS-Arrays durch folgende Eigenschaften aus:
- Mit der BICMOS-Schaltungstechnik lassen sich flächengünstig lastunempfindliche Treiberstufen realisieren. Eine Anpassung an die aktuelle Ausgangslast, die ja vor der Plazierung und Verdrahtung nicht bekannt ist, kann entfallen.
- Der geringe Innenwiderstand der Bipolarstufe reduziert auch die Taktverschleifung, die gerade bei großflächigen Arrays die maximale Systemgeschwindigkeit vermindert.
- Bei hohen kapazitiven Lasten sind Bipolartreiberstufen in ihrer Leistungsaufnahme günstiger.
- Alle gängigen Signalpegel CMOS/ECL/TTL können auf einem BICMOS-Array ohne Leistungseinbußen implementiert werden.
- Die Bauelementvielfalt (Bipolar und MOS) ermöglicht zudem die Realisierung hochwertiger Analogkompenenten direkt auf dem SOG-Array oder in einem zusätzlichen Analogbereich.

Das durch die oben genannte Druckschrift geoffenbarte BICMOS-SOG-Array bestehend aus BICMOS-Basiszellen, stellt ein Universalarray mit breitem Applikationsbereich dar. Das Kennzeichen dieses bekannten Arrays ist der Aufbau aus einer einzigen Basiszelle, die nicht auf eine spezielle Schaltungsstruktur, z. B. statische NAND-Logik hin optimiert ist, sondern verschiedene Entwurfsstile zuläßt. Somit ermöglicht eine solche Grundstruktur neben statischer Logik auch die Implementierung dynamischer Stufen und Speicher, beispielsweise SRAMs.

Diese bekannte Basiszellenstruktur ist jedoch wenig kompakt, da sie hauptsächlich die Oxyd-Isolation benutzt. Die sehr komplexe Anordnung der verschiedenen Transistorbereiche erschwert zudem den effizienten Einsatz von rechnergestützten Entwurfsmitteln.

Die Aufgabe der vorliegenden Erfindung besteht daher darin, eine Basiszelle der eingangs genannten Art anzugeben, die einen weiten Anwendungsbereich abdeckt, kompakt ist und eine hohe Verdrahtbarkeit aufweist.

Die Lösung dieser Aufgabe ist durch die kennzeichnenden Merkmale des Patentanspruches 1 gegeben.

Die Erfindung besteht darin, daß sich also jeweils zwei Reihen von NMOS-Feldeffekttransistoren und eine Reihe von PMOS-Feldeffekttransistoren in der hier aufgezählten Reihenfolge auf gegenüberliegenden Seiten einer BICMOS-Komponente anschließen, wobei eine bestimmte Aufteilung in gate-isolierten und oxyd-isolierten Feldeffekttransistoren vorgenommen ist. Hierbei handelt es sich bei gate-isolierten Feldeffekttransistoren um solche Feldeffekttransistoren, deren Gates auf einem gemeinsamen n- oder p-dotierten Gebiet angeordnet sind, wobei durch jedes Gate ein Feldeffekttransistor realisiert wird. Nun kann von drei benachbarten Feldeffekttransistoren der mittlere so angesteuert werden, indem dessen Gate auf ein entsprechendes Potential gelegt wird, daß die beiden äußeren Feldeffekttransistoren voneinander elektrisch isoliert sind. Im Gegensatz hierzu ist jedem oxyd-isolierten sein eigenes n- oder p-dotiertes Gebiet zugeordnet, die elektrisch voneinander isoliert sind, beispielsweise durch Siliziumdioxyd (SiO₂).

Durch diese spezielle Anordnung der Transistorreihen ist ein mit einer solchen erfindungsgemäßen Basiszelle aufgebautes SOG-Array universell verwendbar. So können sowohl statische und dynamische Logikkomponenten als auch RAM- und ROM-Speicher sowie Eingangs- und Ausgangstreiberstufen implementiert werden.

Die Realisierung einer Schaltung auf einem mit einer solchen erfindungsgemäßen Basiszelle aufgebauten SOG-Array wird zudem erleichtert durch die Aufteilung in MOS-Feldeffekttransistorreihen und den zentralen Bereich, da dort BICMOS-Treiberstufen verwirklicht werden können, ohne die Verdrahtung der CMOS-Logik zu stören.

Ferner wird durch die spezielle Ausgestaltung der Gate-Elektroden mit deren versetzten Anschlußbereichen eine hohe Verdrahtbarkeit erzielt, denn wenn beispielsweise ein Gate-Anschluß durch eine Leitbahn abgedeckt wird, so kann das entsprechende Gate trotzdem über seinen zweiten Gateanschluß kontaktiert werden. Eine hohe Durchlässigkeit ist ferner dadurch gegeben, daß beispielsweise gegenüberliegende Reihen über die im zentralen Bereich der Basiszelle angeordneten BICMOS-Komponente hinweg miteinander verbindbar sind, ohne hierdurch die Funktion der BICMOS-Komponente zu stören.

Schließlich wird eine hohe Packungsdichte durch den Einsatz sowohl von oxyd-isolierten als auch gate-isolierten Feldeffekttransistoren ermöglicht, wodurch beispielsweise ein RAM-Speicher mit BICMOS-Treiberstufen in einem kompakten Design herstellbar ist.

Bei einer ersten vorteilhaften Weiterbildung der Erfindung sind die Anschlußbereiche der Gate-Elektroden der MOS-Feldeffektransistoren jeweils der ersten und dritten Reihe gleichsinnig versetzt, während diejenigen Anschlußbereiche der Gate-Elektroden der MOS-Feldeffekttransistoren jeweils der zweiten Reihe in Bezug auf diejenigen der MOS-Feldeffektransistoren der ersten und dritten Reihen gegensinnig versetzt sind. Hierdurch wird weiter die universelle Anwendbarkeit der mit einer solchen Basiszelle aufgebauten SOG-Array-Anordnung verbessert.

Die Durchlässigkeit wird dahingehend verbessert, daß gemäß einer anderen vorteilhaften Weiterbildung der Erfindung die Gate-Elektroden mit deren Anschlußbereichen der MOS-Feldeffekttransistoren der ersten, zweiten und dritten Reihen bezüglich des zentralen Bereiches spiegelsymmetrisch angeordnet sind.

Nach Anspruch 4 ist die Kanalbreite der Feldeffekttransistoren der dritten Reihen ungefähr doppelt so groß wie diejenige der Feldeffekttransistoren der zweiten Reihen. Diese vorteilhafte Weiterbildung der Basiszelle bietet den Vorteil, daß symmetrische Flanken bei CMOS-Gattern verwirklichbar sind.

Nach Anspruch 5 beträgt die Kanalbreite der Feldeffekttransistoren der ersten Reihe ungefähr die Hälfte wie diejenige der Feldeffekttransistoren der zweiten Reihen. Diese vorteilhafte Weiterbildung der Basiszelle verbessert die Störsicherheit von statischen RAM-Zellen, die auf der Basiszelle hergestellt werden.

Weitere vorteilhafte Weiterbildungen der Erfindung sind in den Unteransprüchen 7 bis 12 gekennzeichnet.

Gemäß Anspruch 13 kann in vorteilhafter Weise die erfindungsgemäße Basiszelle zum Aufbau einer aus Zeilen und Spalten bestehenden SOG-Array-Anordnung verwendet werden. Insbesondere sind bei einer bevorzugten Weiterbildung eines SOG-Arrays dessen Zeilen aus in X-Richtung aneinandergereihten Basiszellen aufgebaut. Solche in Y-Richtung aneinandergereihte Zeilen ergeben dann das ganze SOG-Array, wobei dann insbesondere die vorteilhafte Möglichkeit besteht, beispielsweise eine CMOS-Komponente über zwei benachbarte Zeilen derart übergreifend zu realisieren, indem die dritten und vierten Zeilen jeweils der beiden aneinandergrenzenden Basiszellen verwendet werden. Schließlich ergibt eine sonders bevorzugte Weiterbildung der SOG-Array-Anordnung durch den Aufbau derselben mit 29 Zeilen und 125 Spalten.

Im folgenden soll die Erfindung anhand von Ausführungsbeispielen im Zusammenhang mit den Zeichnungen näher erläutert und beschrieben werden.

Es zeigen:
- Figur 1: ein Ausführungsbeispiel des Layouts einer erfindungsgemäßen Basiszelle,
- Figur 2: ein Schaltbild des Layouts gemäß der Figur 1,
- Figur 3: ein Ausführungsbeispiel für ein Layout mit Vertikal-Verdrahtung,
- Figur 4: ein Ausführungsbeispiel für ein Layout eines NAND-Gatters mit zwei Eingängen,
- Figur 5: ein dem Layout gemäß der Figur 4 entsprechenden Schaltbild,
- Figur 6: ein weiteres Ausführungsbeispiel für ein Layout einer RAM-Speicherzelle,
- Figur 7: ein dem Layout gemäß der Figur 6 entsprechenden Schaltbild,
- Figur 8: ein weiteres Ausführungsbeispiel für ein Layout einer BICMOS-Treiberstufe,
- Figur 9: ein dem Layout gemäß der Figur 8 entsprechenden Schaltbild.

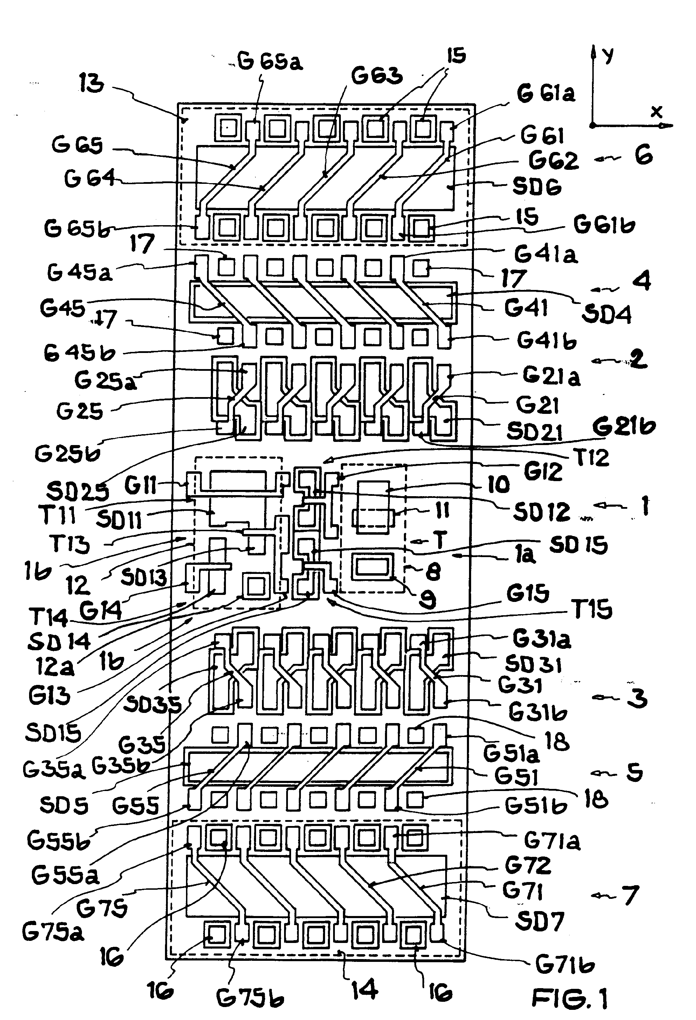

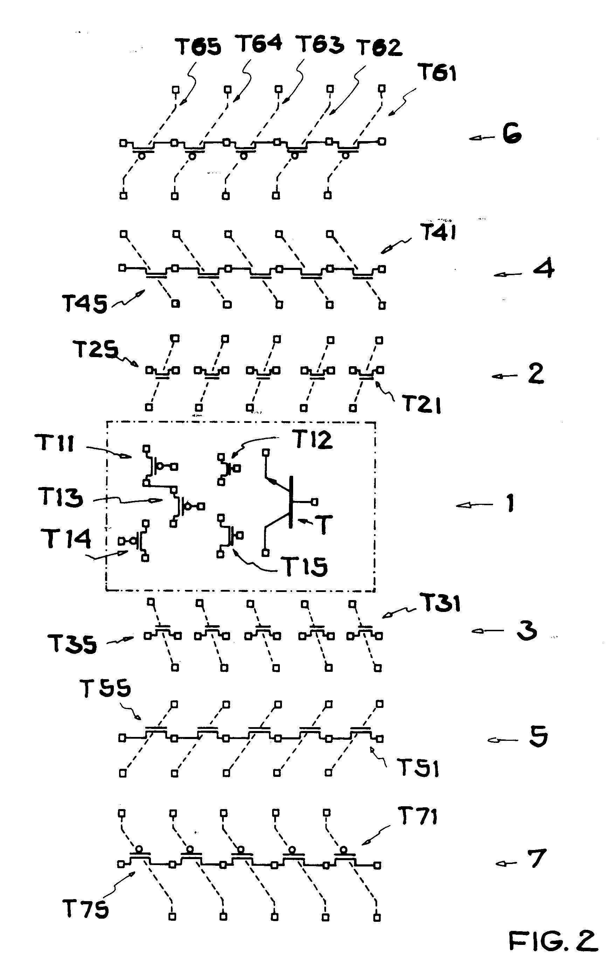

Das Schaltbild der Figur 2 entspricht dem in Figur 1 dargestellten Layout einer erfindungsgemäßen Basiszelle, weshalb beide Figuren gemeinsam erläutert werden. Aus dem Layout der Figur 1 ist die rechteckförmige Form der Basiszelle ersichtlich mit einer Größe von ca. 175 x 50 µm. In einem zentralen Bereich 1 dieser Basiszelle ist eine BICMOS-Komponente angeordnet, die in X-Richtung in zwei Bereiche 1a und 1b aufgeteilt ist. In dem ersten Bereich 1a ist ein Bipolar-Transistor T vorgesehen, der gemäß dem Layout aus einem Kollektorbereich 8 mit dessen Kollektoranschlußbereich 9, dem Basisbereich 10 und dem Emitterbereich 11 aufgebaut ist. Dem Layout zufolge sind der Kollektoranschlußbereich 9, der Basisbereich 10 und der Emitterbereich 11 in Y-Richtung angeordnet. Der Bereich 1b trägt den CMOS-Teil der BICMOS-Komponente und umfaßt die MOS-Feldeffekttransistoren T11, T12, T13, T14 und T15. Diese genannten MOS-Feldeffekttransistoren sind in den Eckpunkten sowie in dem Diagonalenschnittpunkt dieses zweiten Bereiches 1b angeordnet. Hierbei sind die Transistoren T11, T13 und T14 vom p-Kanaltyp und sind deshalb gemäß dem Layout in einem n-dotierten Gebiet 12, beispielsweise einer Wanne, angeordnet, während die verbleibenden beiden Transistoren T12 und T15 n-Kanaltransistoren sind, die in einem p-dotierten Gebiet angeordnet sind. Weiterhin ist aus dem Layout gemäß der Figur 1 ersichtlich, daß deren Source-Drain-Bereiche SD11, SD12, SD13, SD14 und SD15 in Y-Richtung orientiert sind, weshalb deren Gate-Elektroden G11, G12, G13, G14 und G15 in senkrechter Richtung hierzu, also in X-Richtung angelegt sind. Weiterhin sind die beiden Source-Drain-Bereiche der MOS-Feldeffekttransistoren T11 und T13 miteinander verbunden, wie es auch gemäß dem Schaltbild der Figur 2 dargestellt ist. Schließlich ist in dem n-dotierten Bereiche 12, zwischen dem Transistor T14 und T15 ein Kontakt 12a zum n-Gebiet 12 vorgesehen.

Nun sind beidseitig des die Bipolar-Komponente tragenden zentralen Bereiches 1, in Y-Richtung jeweils eine erste Reihe 2 bzw. 3 von fünf in X-Richtung aneinandergereihte oxyd-isolierte MOS-Feldeffekttransistoren T21 bis T25 bzw. T31 bis T35 vom n-Kanaltyp angeordnet. Diese MOS-Feldeffekttransistoren der ersten Reihen 2 und 3 sind aus in Y-Richtung ausgedehnten Source-Drain-Bereichen SD21 bis SD25 und SD31 bis SD35 aufgebaut. Die zugehörigen Gate-Elektroden G21 bis G25 und G31 bis G35 weisen in Bezug auf die Y-Richtung einen schrägen Verlauf auf und sind über die zugehörigen Source-Drain-Bereiche SD21 bis SD25 und SD31 bis SD35 geführt. Da diese Gate-Elektroden beidseitig mit einem Anschlußbereich G21a und G21b, bis G25a und G25b bzw. G31a und G31b bis G35a und G35b versehen sind, ergibt sich bezüglich der Y-Richtung eine versetzte Anordnung dieser Gate-Anschlußbereiche.

An diese zweiten Reihen 2 und 3 von MOS-Feldeffekttransistoren schließt sich jeweils eine zweite Reihe 4 bzw. 5 von gate-isolierten MOS-Feldeffekttransistoren T41 bis T45 und T51 bis T55 vom n-Kanaltyp an, die ebenfalls in X-Richtung aneinandergereiht sind. Diese gate-isolierten MOS-Feldeffekttransistoren weisen einen gemeinsamen Bereich SD4 bzw. SD5 auf, während die jedem MOS-Feldeffekttransistor zugeordnete Gate-Elektrode G41 bis G45 und G51 bis G55 schräg über den zugehörigen Bereich SD4 bzw. SD5 geführt ist. Auch diese genannten Gate-Elektroden weisen auf beiden Seiten jeweils einen Gate-Anschlußbereich G41a und G41b bis G45a und G45b bzw. G51a und G51b bis G55a und G55b auf. Demzufolge sind auch diese Gate-Anschlußbereiche bezüglich der Y-Richtung versetzt angeordnet. Zwischen den Gate-Anschlußbereichen sind jeweils Kontakte 17 bzw. 18 zum p-Gebiet vorgesehen.

Ferner schließt sich jeweils an die zweiten Reihen 4 und 5 eine letzte Reihe von gate-isolierten MOS-Feldeffekttransistoren T61 bis T65 und T71 bis T75 vom p-Kanaltyp an, die in X-Richtung aneinandergereiht sind. Gemäß dem Layout der Figur 1 sind diese MOS-Feldeffekttransistoren in einem n-dotiertem Gebiet 13 bzw. 14 angeordnet. Auch diese MOS-Feldeffekttransistoren der Reihen 6 bzw. 7 weisen jeweils einen gemeinsamen Bereich SD6 bzw. SD7 auf. Die Gate-Elektroden G61 bis G65 bzw. G71 bis G75 sind jeweils schräg bezüglich der Y-Richtung über den zugehörigen Bereich SD6 bzw. SD7 geführt. Weiterhin sind auch diese Gate-Elektroden mit jeweils zwei Gate-Anschlußbereiche G61a und G61b bis G65a und G65b bzw. G71a und G71b bis G75a und G75b versehen. Hiermit ergibt sich ebenfalls eine versetzte Anordnung der Gate-Anschlußbereiche bezüglich der Y-Richtung. Ferner sind zwischen den Gate-Anschlußbereichen jeweils Kontakte 15 bzw. 16 zum n-Gebiet 13 bzw. 14 angeordnet.

Die Gate-Elektroden der jeweils zu einer Reihe gehörenden MOS-Feldeffekttransistoren sind parallel zueinander angeordnet. Zudem weisen die Gate-Elektroden jeweils der ersten und dritten Reihen 2 und 6 bzw. 3 und 7 einen parallelen Verlauf auf, während diejenigen der zweiten Reihen 4 und 5 hierzu entgegengesetzt verlaufen. Schließlich sind die Gate-Elektroden der ersten, zweiten und dritten Reihen 2, 3, 4, 5 , 6 und 7 bezüglich des zentralen Bereiches 1 spiegelsymmetrisch angeordnet.

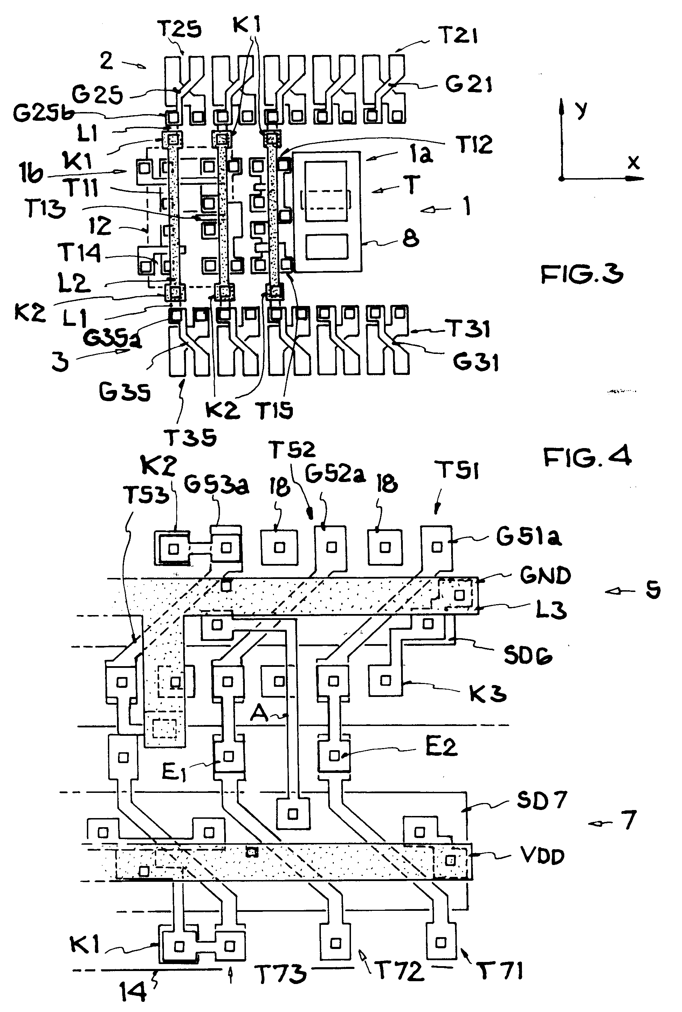

Die Figur 3 zeigt ein Beispiel eines Layouts für eine Vertikal-Verdrahtung der ersten Reihen 2 und 3 einer Basiszelle gemäß der Figur 1, wobei jedoch nur der zentrale Bereich 1 sowie die daran sich anschließenden ersten Reihen 2 und 3 der MOS-Feldeffekttransistoren T21 bis T25 und T31 bis T35 dargestellt sind. Wie schon eingangs erwähnt wurde, sind zur Verdrahtung der einzelnen Bauelemente zwei Metallisierungsebenen aus Aluminium notwendig. Zur Unterscheidung dieser beiden Metallisierungsebenen sind die Leitbahnen L2 der zweiten Metallisierungsebene gegenüber denjenigen der ersten Metallisierungsebene gepunktet gezeichnet. Gemäß dem Layout dieser Figur 3 liegt jeweils zwischen dem Gate-Anschlußbereich G23b, G24b und G25b und dem zweiten Bereich 1b ein Kontaktbereich K1, der die zweite Metallisierungsebene mit der ersten verbindet. In gleicher Weise sind auch jeweils zwischen dem Gate-Anschlußbereich G33a, G34a und G35a und dem zweiten Bereich 1b entsprechende Kontaktbereiche K2 angeordnet. Diese Kontaktbereiche K1 bzw. K2 sind jeweils über eine Leitbahn L1 mit den ihr benachbarten Gate-Anschlußbereichen verbunden, während die in Y-Richtung gegenüberliegenden Kontaktbereiche K1 und K2 jeweils über eine zu der zweiten Metallisierungsebene gehörende Leitbahn L2 verbunden sind. Diese Verdrahtung mit den Leitbahnen L2 der zweiten Metallisierungsebene ist so angelegt, daß die Nutzbarkeit der MOS-Feldeffekttransistoren T11 bis T15 nicht eingeschränkt ist, da gemäß diesem Layout Kontaktbereiche für die Source-Drain-Bereiche als auch für die Gate-Elektroden dieser Transistoren eingezeichnet sind und ohne jegliche Einschränkung durch die Leitbahnen L2 mittels der ersten Metallisierungsebene verdrahtbar sind.

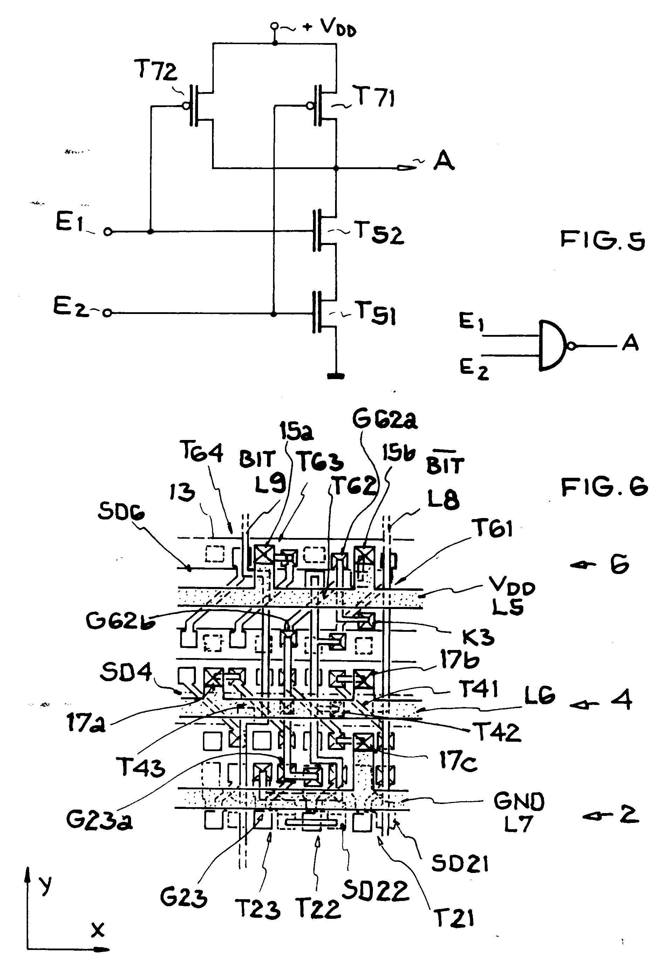

Die Figur 4 zeigt ein Layout eines NAND-Gatters mit zwei Eingängen gemäß dem Schaltbild und dem entsprechenden Symbol der Figur 5. Dieses NAND-Gatter ist mit den MOS-Transistoren T51 bis T53 der Reihe 5 und den MOS-Feldeffekttransistoren T71 bis T73 der Reihe 7 realisiert, demzufolge ist auch nur ein solcher Ausschnitt der Basiszelle gezeichnet. Die Bezugszeichen für die MOS-Feldeffekttransistoren gemäß dem Schaltbild entsprechen denjenigen in dem Layout, so daß eine einfache Zuordnung möglich ist. Daraus ist ersichtlich, daß die MOS-Feldeffekttransistoren T51, T52, T71 und T72 zur Realisierung des NAND-Gatters verwendet werden, während die MOS-Feldeffekttransistoren T53 und T73 zur Isolierung dienen. Weiterhin ist ersichtlich, daß mit der zweiten Metallisierungsebene lediglich zwei Leitbahnen realisiert sind, nämlich eine Leitbahn L3 für den Masseanschluß GND und eine weitere Leitbahn L4 zum Anschluß an die Betriebsspannungsquelle V_{DD}. Diese beiden Leitbahnen L3 und L4 verlaufen in X-Richtung und überdecken teilweise die Bereiche SD5 und SD7. Die restliche Verdrahtung wird auf der ersten Metallisierungsebene vorgenommen. Über Kontakt K1 wird das n-dotierte Gebiet 14 mit der Betriebsspannungsquelle V_{DD} verbunden, während das p-dotierte Gebiet in der Nähe des Bereichs SD6 über die Kontakte K2, K3 auf Massepotential GND gelegt ist. Zwecks besserer Zuordnung zu dem Schaltbild gemäß Figur 5 sind in dem Layout der Ausgang A sowie die beiden Eingänge E1 sowie E2 bezeichnet.

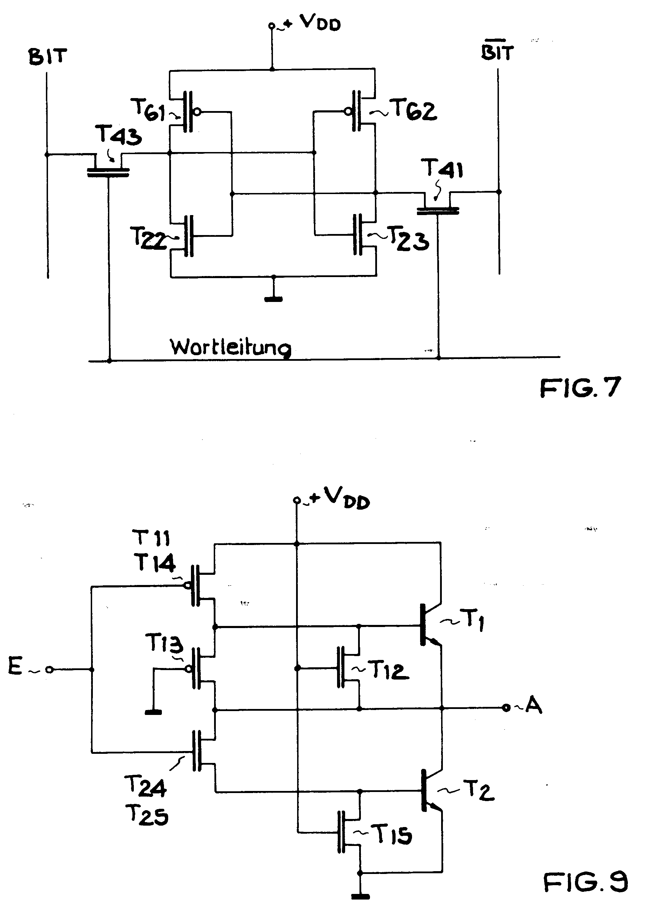

Die Figur 6 zeigt nun das Layout einer statischen RAM-Speicherzelle, deren Schaltbild in Figur 7 dargestellt ist. Diese RAM-Speicherzelle ist mit den MOS-Feldeffekttransistoren T61, T62, T41, T42, T43, T22 und T23 der Reihen 6, 4 und 2 realisiert. Das Layout zeigt deshalb nur den entsprechenden Ausschnitt aus der Basiszelle gemäß der Figur 2. Zur Versorgung der Speicherzelle mit einer Betriebsspannungsquelle V_{DD} ist eine Leitbahn L5 der zweiten Metallisierungsebene parallel über den Bereich SD6 gezogen und ist ferner mit jeweils einem durchgezogen gekennzeichneten Diagonalkreuz bezeichnete Kontaktbereichen 15a und 15b verbunden. Solche mit einem durchgezogen gezeichneten Diagonalkreuz bezeichneten Kontaktbereiche stellen die Verbindung zwischen der zweiten und der ersten Metallisierungsebene her. Diejenigen Kontaktbereiche dagegen, die mit einem unterbrochen gezeichneten Diagonalkreuz bezeichnet sind, stellen die Verbindung zwischen der ersten Metallisierungsebene und den Gate-Elektroden bzw. den Diffusionsgebieten her. So ist beispielsweise das Gate-Anschlußgebiet G62a des Feldeffekttransistors T62 mit der ersten Metallisierungsebene kontaktiert und wird über eine Leitbahn dieser ersten Metallisierungsebene mit einem Kontakt K3 verbunden, der den darunterliegenden Bereich SD6 kontaktiert. Ferner ist das Gate G62 des Feldeffekttransistors T62 über dessen Gate-Anschlußbereich G62b ebenfalls über eine Leitbahn der ersten Metallisierungsebene sowohl mit dem Bereich SD4 als auch mit der Gate-Elektrode G23 des Feldeffekttransistors T23 über dessen Gate-Anschlußbereich G23a als auch mit dem Source-Drain-Bereich SD22 des MOS-Feldeffekttransistors T22 verbunden, vergleiche hierzu Schaltbild gemäß Figur 7. Weiterhin führt eine Leitbahn L6 der zweiten Metallisierungsebene ebenfalls parallel über den Bereich SD4 der MOS-Feldeffekttransistoren der zweiten Reihe 4, die als Wortleitung dient. Diese Leitbahn L6 ist ferner über die die beiden Metallisierungsebene verbindenden Kontaktbereiche 17a bzw. 17b mit den Gate-Anschlußbereichen G43a bzw. G42a verbunden, denen die Gate-Elektroden G43 und G42 der MOS-Feldeffekttransistoren T43 und T42 zugeordnet sind. Die Verbindung zwischen diesem Kontaktbereich 17a bzw. 17b und dem Gate-Anschlußbereich G43a bzw. G41a stellt eine Leitbahn der ersten Metallisierungsebene her. Schließlich ist eine dritte Leitbahn L7 der zweiten Metallisierungsebene parallel über die MOS-Feldeffekttransistoren der ersten Reihe 2 geführt und dient als Bezugspotential GND. Ferner führt diese Leitbahn L7 zu einem die beiden Metallisierungsebenen verbindenden Kontaktbereich 17c, der über eine Leitbahn der ersten Metallisierungsebene mit dem Gate G42 über dessen Gate-Anschlußbereich G42b angeschlossen ist. Der zugehörige MOS-Feldeffekttransistor T42 dient zur Isolation der beiden benachbarten MOS-Feldeffekttransistoren T41 und T43. Schließlich stellen die beiden Leitungen L8 und L9 der ersten Metallisierungsebene die Bit- bzw. B̅i̅t̅-Leitungen dar.

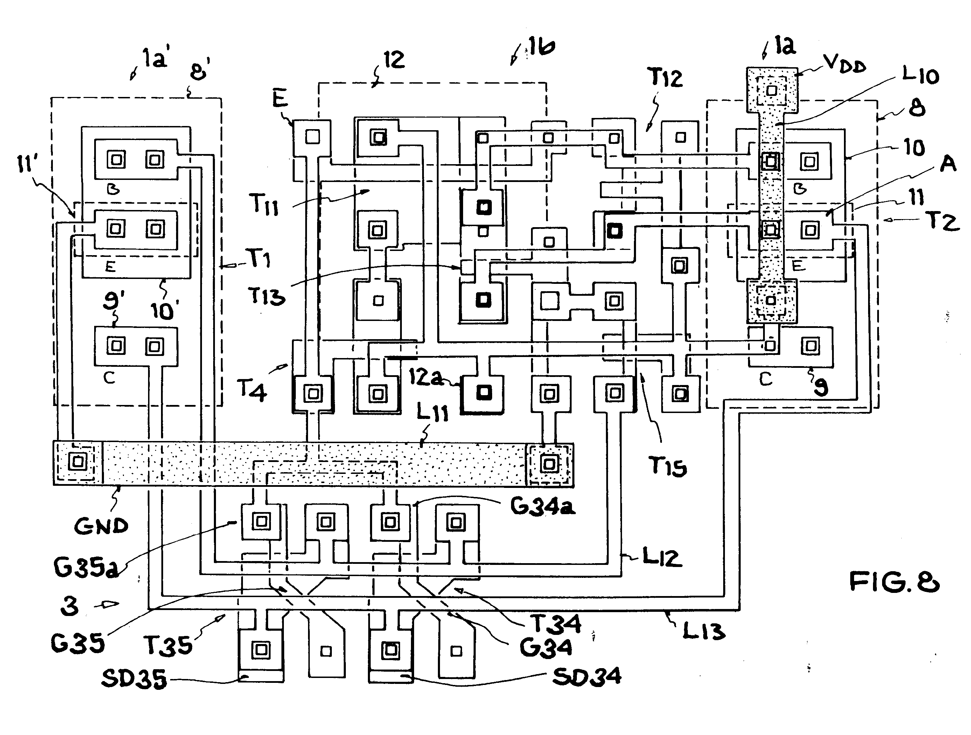

Die Figur 8 zeigt schließlich das Layout einer BICMOS-Treiberstufe gemäß dem Schaltbild der Figur 9. Dieses Layout zeigt nur den zentralen Bereich 1 einer Basiszelle sowie die MOS-Feldeffekttransistoren T34 und T35 der ersten Reihe 3 sowie den ersten Bereich 1a' eines zentralen Bereiches 1' einer benachbarten Basiszelle. Die beiden npn-Transistoren der ersten Bereiche 1a und 1a' werden gemäß dem Schaltbild nach Figur 9 als Endstufentransistoren T1, T2 eingesetzt. Die beiden p-Kanalfeldeffekttransistoren T11 und T14 des zweiten Bereiches 1b sind auf der ersten Metallisierungsebene parallel verschaltet und stellen gemäß der Schaltung nach Figur 9 den Transistor T11/T14 dar. Ebenso sind die beiden MOS-Feldeffekttransistoren T34 und T35 in der ersten Metallisierungsebene parallel verdrahtet und stellen gemäß Figur 9 den Transistor T24/T25 dar. Hierbei sind die beiden Gate-Anschlußbereiche G34a und G35a über eine Leitbahn der ersten Metallisierungsebene verbunden sowie die beiden Source-Drain-Bereiche SD34 und SD35 über die beiden Leitungen L12 und L13. Eine erste Leitbahn L10 der zweiten Metallisierungsebene dient zur Zuführung der Betriebsspannungsquelle V_{DD} und eine zweite Leitbahn L11 der zweiten Metallisierungsebene dient als Bezugspotential GND. Schließlich sind gemäß der Schaltung nach Figur 9 der Eingang E sowie der Ausgang A auch in dem Layout gemäß der Figur 8 bezeichnet.

Eine solche BICMOS-Treiberstufe kann nun zusammen mit Logik-Einheiten auf einem mit der erfindungsgemäßen Basiszelle aufgebauten SOG-Array implementiert werden, beispielsweise ein Schieberegister mit zwei BICMOS-Treiberstufen am Ausgang.

Ein solches SOG-Array kann beispielsweise aus 29 Reihen und 125 Spalten solcher erfindungsgemäßen Basiszellen aufgebaut werden, wobei die Zeilen aus aneinandergereihten Basiszellen aufgebaut sind. Die Größe eines solchen SOG-Arrays beträgt beispielsweise 6,25 x 5,075 mm, das einer Fläche von 31,72 mm² entspricht. Dieses SOG-Array enthält dann 126 875 MOS-Feldeffekttransistoren, wovon 79 750 NMOS-Feldeffekttransistoren und 43 500 PMOS-Feldeffekttransistoren, sowie 3625 NPN-Transistoren. Hierbei betragen die Verzögerungszeiten für CMOS-Inverter ca. 300 ps, wenn dieser Inverter mit einem baugleichen Inverter belastet wird. Zur Umladung einer kapazitiven Last von ca. 1 pF benötigt eine BICMOS-Treiberstufe nach Figur 8 ca. 600 ps.

## Patentansprüche

1. Basiszelle für eine kanallose Gate-Array-Anordnung (SOG)-Array) in einer CMOS- und Bipolar-Technologie kombinierenden Technik, wobei jede Basiszelle wenigstens einen Bipolar-Transistor und mehrere Metalloxyd-Feldeffekttransitoren (MOSFET) umfaßt, deren Gate-Elektroden jeweils zwei Anschlußbereiche aufweisen, die auf gegenüberliegenden Seiten des zugehörigen Source-Drain-Bereiches liegen, dadurch gekennzeichnet, daß in einem zentralen Bereich (1) der Basiszelle der Bipolar-Transistor (T) als auch MOS-Feldeffekttransistoren (T11, T12, T13, T14, T15) vom ersten als auch vom zweiten Kanaltyp angeordnet sind, daß auf gegenüberliegenden Seiten des zentralen Bereiches (1) jeweils drei parallel zueinander ausgerichtete Reihen (2, 3, 4, 5, 6, 7) von mindestens zwei MOS-Feldeffekttransistoren (T21, ..., T25, T31, ... T35, T41, ..., T45, T51, ... T55, T61, ..., T65, T71, ..., T75) vorgesehen sind, daß die jeweils dem zentralen Bereich (1) benachbarte erste Reihe (2, 3) aus oxyd-isolierten MOS-Feldeffekttransistoren (T21, ..., T25, T31, ..., T35) vom ersten Kanaltyp aufgebaut ist, daß die an die ersten Reihen (2, 3) sich jeweils anschließende zweite Reihe (4, 5) aus gate-isolierten MOS-Feldeffekttransistoren (T41, ..., T45, T51, ..., T55) vom ersten Kanaltyp aufgebaut ist, daß die an die zweiten Reihen (4, 5) sich jeweils anschliessende dritte Reihe (6, 7) aus gate-isolierten MOS-Feldeffektransistoren (T61, ..., T65, T71, ..., T75) vom zweiten Kanaltyp aufgebaut ist, daß jeweils die beiden Anschlußbereiche (G21a, G21b; G22a, G22b; ...; G75a, G75b) der Gate-Elektroden (G21, G22, ..., G75) der MOS-Feldeffekttransistoren (T21, ..., T75) der ersten, zweiten und dritten Reihen (2, 3, 4, 5, 6, 7) in Bezug auf die zur Richtung (X) der Reihen (2, 3, 4, 5, 6, 7) senkrechte Orientierung (Y) gegeneinander versetzt angeordnet sind, und daß die Gate-Elektroden (G21, ... ) mit deren Anschlußbereichen (G21a, G21b; ... ) der zu einer Reihe (2, ... ) gehörenden MOS-Feldeffekttransistoren (T21, ..., T25, ... ) parallel zueinander ausgerichtet sind.

2. Basiszelle nach Anspruch 1, dadurch gekennzeichnet, daß die Anschlußbereiche (G21a, G21b; ...; G25a, G25b; G31a, G31b; ...; G35a, G35b; G61a, G61b; ...; G65a, G65b; G71a, G71b; ...; G75a, G75b) der Gate-Elektroden (G21, ..., G25, G31, ..., G35, G61, ..., G65, G71, ..., G75) der MOS-Feldeffekttransistoren (T21, ... T25, T31, ..., T35, T61, ..., T65, T71, ..., T75) jeweils der ersten und dritten Reihe (2, 3, 6, 7) gleichsinnig versetzt sind, und daß die Anschlußbereiche (G41a, G41b; ...; G45a, G45b; G51a, G51b; ...; G55a, G55b) der Gate-Elektroden (G41, ..., G45, G51, ..., G55) der MOS-Feldeffekttransistoren (T41, ..., T45, T51, ..., T55) jeweils der zweiten Reihe (4, 5) in Bezug auf diejenigen der MOS-Feldeffekttransistoren der ersten und dritten Reihen (2, 3, 6, 7) gegensinnig versetzt sind.

3. Basiszelle nach Anspruch 2, dadurch gekennzeichnet, daß die Gate-Elektroden mit deren Anschlußbereichen der MOS-Feldeffekttransistoren (T21, ..., T75) der ersten, zweiten und dritten Reihen (2, 3, 4, 5, 6, 7) bezüglich des zentralen Bereiches (1) spiegelsymmetrisch angeordnet sind.

4. Basiszelle nach einem der vorangehenden Ansprüche, dadurch gekennzeichnet, daß bei annähernd gleicher Kanallänge die Kanalbreite der Feldeffekttransistoren (T61, ..., T65, T71, ..., T75) der dritten Reihen (6, 7) ungefähr doppelt so groß ist wie diejenige der Feldeffekttransistoren (T41, ..., T45, T51, ..., T55) der zweiten Reihen (4, 5).

5. Basiszelle nach einem der vorangehenden Ansprüche, dadurch gekennzeichnet, daß bei annähernd gleicher Kanallänge die Kanalbreite der Feldeffekttransistoren (T51, ..., T55, T41, ..., T45) der zweiten Reihen (4, 5) ungefähr doppelt so groß ist wie diejenige der Feldeffekttransistoren (T21, ..., T25, T31, ..., T35) der ersten Reihen (2, 3).

6. Basiszelle nach einem der vorangehenden Ansprüche, dadurch gekennzeichnet, daß sich der zentrale Bereich (1) aus einem ersten und zweiten rechteckförmigen Bereich (1a, 1b) zusammensetzt, die sich in der durch die Reihen (2, 3, 4, 5, 6, 7) vorgegebenen Richtung (X) aneinanderreihen, daß in den Eckpunkten des ersten rechteckförmigen Bereiches (1a) als auch im Schnittpunkt dessen Diagonalen jeweils ein MOS-Feldeffekttransistor (T11, ..., T15) angeordnet ist und daß im zweiten rechteckförmigen Bereich (1b) der Bipolar-Transistor (T) hergestellt ist.

7. Basiszelle nach Anspruch 6, dadurch gekennzeichnet, daß die Drain-Source-Bereiche (SD11, ..., SD15) der fünf, in dem ersten rechteckförmigen Bereich (1a) angeordneten MOS-Feldeffekttransistoren (T11, ..., T15) sich senkrecht zur Richtung (X) der Reihen (2, ..., 7) erstrecken, daß deren Gate-Elektroden (G11, ..., G15) parallel zu der durch die Reihen (2, ..., 7) vorgegebenen Richtung (X) angeordnet sind, und daß die Kollektor-, Basis- und Emitteranschlußbereiche (9, 10, 11) des Bipolar-Transistors (T) zueinander senkrecht zu der durch die Reihen (2, ..., 7) vorgegebenen Richtung (X) angeordnet sind.

8. Basiszelle nach Anspruch 6 oder 7, dadurch gekennzeichnet, daß die in den jeweils zu der ersten Reihe (2, 3) benachbarten Eckpunkten des ersten rechteckförmigen Bereiches (1a) angeordneten MOS-Feldeffekttransistoren (T11, T12, T14, T15) vom ersten Kanaltyp und vom zweiten Kanaltyp sind, und daß der in dem Diagonalenschnittpunkt des ersten rechteckförmigen Bereiches (1a) angeordnete MOS-Feldeffekttransistor (T13) vom zweiten Kanaltyp ist.

9. Basiszelle nach Anspruch 8, dadurch gekennzeichnet, daß die zum Rand der Basiszelle benachbarten, in den Eckpunkten des ersten rechteckförmigen Bereiches (1a) angeordneten MOS-Feldeffekttransistoren (T11, T14) vom zweiten Kanaltyp sind, und daß die in den beiden anderen Eckpunkten des ersten rechteckförmigen Bereiches (1a) angeordneten MOS-Feldeffekttransistoren (T12, T15) vom ersten Kanaltyp sind.

10. Basiszelle nach Anspruch 9, dadurch gekennzeichnet, daß der Source-Drain-Bereich (SD13) des in dem Diagonalenschnittpunkt des ersten rechteckförmigen Bereiches (1a) angeordneten MOS-Feldeffekttransistors (T13) mit dem Source-Drain-Bereich (SD11) eines der zum Rand der Basiszelle benachbarten, in den Eckpunkten des ersten rechteckförmigen Bereiches (1a) angeordneten MOS-Feldeffekttransistors (T11) verbunden ist.

11. Basiszelle nach einem der vorangehenden Ansprüche, dadurch gekennzeichnet, daß MOS-Feldeffekttransistoren vom ersten Kanaltyp n-Kanaltransistoren sind, daß MOS-Feldeffekttransistoren vom zweiten Kanaltyp p-Kanaltransistoren sind und daß der Bipolar-Transistor (T) ein npn-Transistor ist.

12. Basiszelle nach einem der vorangehenden Ansprüche, dadurch gekennzeichnet, daß die ersten, zweiten und dritten Reihen (2, 3, ..., 7) jeweils fünf MOS-Feldeffekttransistoren (T21, ..., T25, T31, ..., T35 ..., T71, ..., T75) aufweisen.

13. Kanallose Gate-Array-Anordnung (SOG-Array), welche aus Zeilen und Spalten besteht und mit der Basiszelle nach einem der vorangehenden Ansprüche aufgebaut ist.

14. Kanallose Gate-Array-Anordnung (SOG-Array) nach Anspruch 13, dadurch gekennzeichnet, daß die Zeilen aus in X-Richtung aneinandergereihten Basiszellen aufgebaut sind.

15. Kanallose Gate-Array-Anordnung (SOG-Array) nach Anspruch 13 oder 14, gekennzeichnet durch 29 Zeilen und 125 Spalten.

## Claims

1. Base cell for a ductless gate array (SOG array) in engineering merging CMOS and bipolar technology, each base cell comprising at least one bipolar transistor and a plurality of metal-oxide field-effect transistors (MOSFETs), whose gate electrodes each have two terminal regions lying on opposite sides of the associated source drain region, characterized in that the bipolar transistor (T) and MOS field-effect transistors (T11, T12, T13, T14, T15) of the first and of the second channel type are disposed in a central region (1) of the base cell, that on opposing sides of the central region (1) there are provided in each case three parallel-directed rows (2, 3, 4, 5, 6, 7) of at least two MOS field-effect transistors (T21, ..., T25, T31, ... T35, T41, ..., T45, T51, ... T55, T61, ..., T65, T71, ..., T75), that each first row (2, 3) adjacent to the central region (1) is assembled from oxide-isolated MOS field-effect transistors (T21, ..., T25, T31, ..., T35) of the first channel type, that each second row (4, 5) adjoining the first rows (2, 3) is assembled from gate-isolated MOS field-effect transistors (T41, ..., T45, T51, ..., T55) of the first channel type, that each third row (6, 7) adjoining the second rows (4, 5) is assembled from gate-isolated MOS field-effect transistors (T61, ..., T65, T71, ..., T75) of the second channel type, that the two terminal regions (G21a, G21b; G22a, G22b; ...; G75a, G75b) of each of the gate electrodes (G21, G22, ..., G75) of the MOS field-effect transistors (T21, ..., T75) of the first, second and third rows (2, 3, 4, 5, 6, 7) are disposed offset relative to one another in relation to the orientation (Y) at right angles to the direction (X) of the rows (2, 3, 4, 5, 6, 7), and that the gate electrodes (G21, ...) with their terminal regions (G21a, G21b; ...) of the MOS field-effect transistors (T21, ..., T25, ...) belonging to a row (2, ...) are aligned parallel to one another.

2. Base cell according to claim 1, characterized in that the terminal regions (G21a, G21b; ...; G25a, G25b; G31a, G31b; ...; G35a, G35b; G61a, G61b; ...; G65a, G65b; G71a, G71b; ...; G75a, G75b) of the gate electrodes (G21, ..., G25, G31, ..., G35, G61, ..., G65, G71, ..., G75) of the MOS field-effect transistors (T21, ... T25, T31, ..., T35, T61,..., T65, T71, ..., T75) of each first and third rows (2, 3, 6, 7) are offset in the same direction, and that the terminal regions (G41a, G41b; ...; G45a, G45b; G51a, G51b; ...; G55a, G55b) of the gate electrodes (G41, ..., G45, G51, ..., G55) of the MOS field-effect transistors (T41, ..., T45, T51, ..., T55) of each second row (4, 5) are offset in the opposite direction in relation to those of the MOS field-effect transistors of the first and third rows (2, 3, 6, 7).

3. Base cell according to claim 2, characterized in that the gate electrodes with their terminal regions of the MOS field-effect transistors (T21, ..., T75) of the first, second and third rows (2, 3, 4, 5, 6, 7) are disposed mirror-symmetrically relative to the central region (1).

4. Base cell according to one of the preceding claims, characterized in that, given an approximately identical duct length, the duct width of the field-effect transistors (T61, ..., T65, T71, ..., T75) of the third rows (6, 7) is approximately twice as great as that of the field-effect transistors (T41, ..., T45, T51, ..., T55) of the second rows (4, 5).

5. Base cell according to one of the preceding claims, characterized in that, given an approximately identical duct length, the duct width of the field-effect transistors (T51, ..., T55, T41, ..., T45) of the second rows (4, 5) is approximately twice as great as that of the field-effect transistors (T21, ..., T25, T31, ..., T35) of the first rows (2, 3).

6. Base cell according to one of the preceding claims, characterized in that the central region (1) comprises a first and second rectangular region (1a, 1b) which are butt-mounted in the direction (X) predetermined by the rows (2, 3, 4, 5, 6, 7), that one MOS field-effect transistor (T11, ..., T15) is disposed in each of the corner points of the first rectangular region (1a) and at the point of intersection of the diagonals of said region and that the bipolar transistor (T) is manufactured in the second rectangular region (1b).

7. Base cell according to claim 6, characterized in that the drain source regions (SD11, ..., SD15) of the five MOS field-effect transistors (T11, ..., T15) disposed in the first rectangular region (1a) extend at right angles to the direction (X) of the rows (2, ..., 7), that their gate electrodes (G11, ..., G15) are disposed parallel to the direction (X) predetermined by the rows (2, ..., 7), and that the collector, base and emitter terminal regions (9, 10, 11) of the bipolar transistor (T) are disposed in relation to one another at right angles to the direction (X) predetermined by the rows (2, ..., 7).

8. Base cell according to claim 6 or 7, characterized in that the MOS field-effect transistors (T11, T12, T14, T15) disposed in each corner point, adjacent to the first rows (2, 3), of the first rectangular region (1a) are of the first channel type and of the second channel type, and that the MOS field-effect transistor (T13) disposed at the point of intersection of the diagonals of the first rectangular region (1a) is of the second channel type.

9. Base cell according to claim 8, characterized in that the MOS field-effect transistors (T11, T14) adjacent to the edge of the base cell and disposed in the corner points of the first rectangular region (1a) are of the second channel type, and that the MOS field-effect transistors (T12, T15) disposed in the other two corner points of the first rectangular region (1a) are of the first channel type.

10. Base cell according to claim 9, characterized in that the source drain region (SD13) of the MOS field-effect transistor (T13) disposed at the point of intersection of the diagonals of the first rectangular region (1a) is connected to the source drain region (SD11) of a MOS field-effect transistor (T11) adjacent to the edge of the base cell and disposed in the corner points of the first rectangular region (1a).

11. Base cell according to one of the preceding claims, characterized in that MOS field-effect transistors of the first channel type are N-channel transistors, that MOS field-effect transistors of the second channel type are P-channel transistors and that the bipolar transistor (T) is an n-p-n transistor.

12. Base cell according to one of the preceding claims, characterized in that the first, second and third rows (2, 3, ..., 7) each comprise five MOS field-effect transistors (T21, ... T25, T31, ..., T35 ..., T71, ..., T75).

13. Ductless gate array (SOG array) which comprises lines and columns and is assembled with the base cell according to one of the preceding claims.

14. Ductless gate array (SOG array) according to claim 13, characterized in that the lines are assembled from base cells butt-mounted in X direction.

15. Ductless gate array (SOG array) according to claim 13 or 14, characterized by 29 lines and 125 columns.

## Revendications

1. Cellule de base pour un dispositif de matrice de portes (matrice SOG) sans canal dans une technique combinant la technologie du transistor métal-oxyde-semiconducteur complémentaire CMOS et la technologie bipolaire, chaque cellule de base comportant au moins un transistor bipolaire et plusieurs transistors à effet de champ en technologie métal-oxyde-semiconducteur (MOSFET), dont les électrodes de porte présentent chacune deux zones de bornage qui sont situées des côtés opposés de la zone source-drain correspondante, cellule caractérisée par le fait que dans une zone centrale (1) de la cellule de base sont disposés le transistor bipolaire (T) ainsi que des transistors MOS à effet de champ (T11, T12, T13, T14, T15) aussi bien du premier type de canal que du second type de canal, que sur chacun des côtés opposés de la zone centrale (1) sont prévus trois rangées (2, 3, 4, 5, 6, 7), orientées parallèlement l'une à l'autre, d'au moins deux transistors MOS à effet de champ (T21, ..., T25, T31, ... T35, T41, ..., T45, T51, ... T55, ..., T61, ..., T65, T71, ..., T75), que chacune des premières rangées (2, 3) voisines de la zone centrale (1) est constituée de transistors MOS à effet de champ à isolation par oxyde (T21, ..., T25, T31, ..., T35) du premier type de canal, que chacune des secondes rangées (4, 5) qui jouxtent les premières rangées (2, 3) sont constituées de transistors MOS à effet de champ à porte isolée (T41, ..., T45, T51, ..., T55) du premier type de canal, que chacune des troisièmes rangées (6, 7) qui jouxtent les secondes rangées (4, 5) sont constituées de transistors MOS à effet de champ à porte isolée (T61, ..., T65, T71, ..., T75) du second type de canal, que les deux zones de bornage (G21a, G21b; G22a, G22b; ...; G75a, G75b) des électrodes de porte (G21, G22, ..., G75) des transistors MOS à effet de champ (T21, ..., T75) des premières, secondes et troisièmes rangées (2, 3, 4, 5, 6, 7) sont mutuellement décalées en ce qui concerne l'orientation verticale (Y) dans la direction (X) des rangées (2, 3, 4, 5, 6, 7), et que les électrodes de porte (G21, ... ) sont, par leurs zones de bornage (G21a, G21b; ... ) des transistors MOS à effet de champ (T21, ..., T25, ... ) appartenant à une rangée (2, ... ), sont orientées parallèlement l'une à l'autre.

2. Cellule de base selon la revendication 1, caractérisée par le fait que les zones de bornage (G21a, G21b; ...; G25a, G25b; G31a, G31b; ...; G35a, G35b; G61a, G61b; ...; G65a, G65b; G71a, G71b; ...; G75a, G75b) des électrodes de porte (G21, ..., G25, G31, ..., G35, G61, ..., G65, G71, ..., G75) des transistors MOS à effet de champ (T21, ... T25, T31, ..., T35, T61, ..., T65, T71, ..., T75) de chacune des premières et trosièmes rangées (2, 3, 6, 7) sont décalées dans le même sens, et que les zones de bornage (G41a, G41b, ...; G45a, G45b; G51a, G51b; ...; G55a, G55b) des électrodes de porte (G41, ..., G45, G51, ..., G55) des transistors MOS à effet de champ (T41, ..., T45, T51, ..., T55) de chacune des secondes rangées (4, 5) sont décalées dans le sens opposé au décalage de celles des transistors MOS à effet de champ des premières et troisièmes rangées (2, 3, 6, 7).

3. Cellule de base selon la revendication 2, caractérisée par le fait que les électrodes de porte, par leurs zones de bornage des transistors MOS à effet de champ (T21 ..., T75) des premières, secondes et troisièmes rangées (2, 3, 4, 5, 6, 7), sont disposées par rapport à la zone centrale (1), en symétrie par rapport à un plan.

4. Cellule de base selon l'une des revendications précédentes, caractérisée par le fait que, pour une longueur de canal approximativement égale, la largeur du canal des transistors à effet de champ (T61, ..., T65, T71, ..., T75) des trosièmes rangées (6, 7) est approximativement le double de celle des transistors à effet de champ (T41, ..., T45, T51, ..., T55) des secondes rangées (4, 5),

5. Cellule de base selon l'une des revendications précédentes, caractérisée par le fait que, pour une longueur de canal approximativement égale, la largeur du canal des transistors à effet de champ (T51, ..., T55, T41, ..., T45) des secondes rangées (4, 5) est approximativement le double de celle des transistors à effet de champ (T21, ..., T25, T31, ..., T35) des premières rangées (2, 3).

6. Cellule de base selon l'une des revendications précédentes, caractérisée par le fait que la zone centrale (1) se compose d'une première et d'une seconde zones rectangulaires (1a, 1b) qui sont en rangée l'une à côté de l'autre dans la direction (X) définie par les rangées (2, 3, 4, 5, 6, 7), qu'à chacun des angles de la première zone rectangulaire (1a) ainsi qu'au point d'intersection de ses diagonales est disposé un transistor MOs à effet de champ (T11, ..., T15) et que le transistor bipolaire (T) est réalisé dans la seconde zone rectangulaire (1b).

7. Cellule de base selon la revendication 6, caractérisée par le fait que les zones drain-source (SD11, ..., SD15) des cinq transistors MOS à effet de champ (T11, ..., T15) disposés dans la première zone rectangulaire (1a) s'étendent perpendiculairement à la direction (X) des rangées (2, ..., 7), que leurs électrodes de porte (G11, ..., G15) son disposées parallèlement à la direction (X) définie par les rangées (2, ..., 7) et que les zones de bornage (9, 10, 11) du collecteur, de la base et de l'émetteur du transistor bipolaire (T) forment une disposition perpendiculaire à la direction (X) définie par les rangées (2, ..., 7).

8. Cellule de base selon la revendication 6 ou 7, caractérisée par le fait que les transistors MOS à effet de champ (T11, T12, T14, T15) disposés dans chacun des angles de la première zone rectangulaire (1a) voisins de chacune des premières rangées (2, 3) sont du premier type de canal et du second type de canal et que le transistor MOS à effet de champ (T13) disposé au point d'intersection des diagonales de la première zone rectangulaire (1a) est du second type de canal.

9. Cellule de base selon la revendication 8, caractérisée par le fait que les transistors MOS à effet de champ (T11, T14) disposés au voisinage de la bordure de la cellule de base, dans les angles de la première zone rectangulaire (1a), sont du second type de canal et que les transistors MOS à effet de champ (T12, T15), disposés aux deux autres angles de la première zone rectangulaire (1a) sont du premier type de canal.

10. Cellule de base selon la revendication 9, caractérisée par le fait que la zone source-drain (SD13) du transistor MOS à effet de champ (T13) disposé au point d'intersection des diagonales de la première zone rectangulaire (1a) est reliée à la zone source-drain (SD11) de l'un (T11) des transistors MOS à effet de champ disposés, au voisinage de la bordure de la cellule de base, aux angles de la première zone rectangulaire (1a).

11. Cellule de base selon l'une des revendications précédentes, caractérisée par le fait que les transistors MOS à effet de champ d'un premier type de canal sont des transistors à canal de type N, que les transistors MOS à effet de champ du second type de canal sont des transistors à canal de type P. et que le transistor bipolaire (T) est un transistor NPN.

12. Cellule de base selon l'une des revendications précédentes, caractérisée par le fait que les premières, secondes et troisièmes rangées (2, 3, ..., 7) présentent chacune cinq transistors MOS à effet de champ (T21, ..., T25, T31, ..., T35, ..., T71, ..., T75).

13. Dispositon à matrice de portes (matrice SOG) sans canal qui est constituée de lignes et de colonnes et qui est construite avec la cellule de base conforme à l'une des revendications précédentes.

14. Disposition à matrice de portes (matrice SOG), sans canal, selon la revendication 13, caractérisée par le fait que les lignes sont constituées de cellules de base en rangée l'une à côté de l'autre dans la direction X.

15. Dispositioin à matrice de portes (matrice SOG), sans canal, selon la revendication 13 ou 14, caractérisée par 29 lignes et 125 colonnes.
